Europäisches Patentamt

European Patent Office

Office européen des brevets

(19)

(11) Veröffentlichungsnummer : **0 572 377 B1**

(12) **EUROPÄISCHE PATENTSCHRIFT**

(45) Veröffentlichungstag der Patentschrift :
**21.06.95 Patentblatt 95/25**

(51) Int. Cl.$^6$ : **H03F 1/52, H03F 3/343**

(21) Anmeldenummer : **90911279.9**

(22) Anmeldetag : **27.07.90**

(86) Internationale Anmeldenummer :
**PCT/DE90/00575**

(87) Internationale Veröffentlichungsnummer :
**WO 91/03101 07.03.91 Gazette 91/06**

(54) **DARLINGTON-TRANSISTORSCHALTUNG.**

(30) Priorität : **16.08.89 DE 3926888**

(43) Veröffentlichungstag der Anmeldung :
**08.12.93 Patentblatt 93/49**

(45) Bekanntmachung des Hinweises auf die
Patenterteilung :
**21.06.95 Patentblatt 95/25**

(84) Benannte Vertragsstaaten :
**DE FR GB IT**

(56) Entgegenhaltungen :
**FR-A- 2 556 900**
**GB-A- 2 138 495**
**US-A- 4 074 334**
**US-A- 4 355 341**
**US-A- 4 618 875**

(73) Patentinhaber : **ROBERT BOSCH GMBH**
**Postfach 30 02 20**
**D-70442 Stuttgart (DE)**

(72) Erfinder : **TOPP, Rainer**
**Moselstrasse 61**
**D-7410 Reutlingen (DE)**

EP 0 572 377 B1

## Beschreibung

### Stand der Technik

Die Erfindung betrifft eine Darlington-Transistorschaltung in einem Chip.

Eine bekannte Darlington-Transistorschaltung (US-A-4 618 875) enthält einen Leistungstransistor und einen Treibertransistor, dessen Kollektor an den Kollektor des Leistungstransistors angeschlossen ist und bei der der Leistungstransistor und der Treibertransistor in einem gemeinsamen, die Kollektorzonen der beiden Transistoren bildenden Substrat eines Chips in Planartechnik monolithisch integriert sind. Eine durch eine Siliziumoxidschicht elektrisch isolierte Deckelektroden-Metallisierung erstreckt sich über die Raumladungszone, die sich im Bereich des pn-Übergangs an der Chipoberseite zwischen Basis und Kollektor ausbildet.

Zusätzlich ist ein Spannungsteiler zwischen dem gemeinsamen Kollektor und der Basis des Leistungstransistors vorgesehen mit einer Verbindung des Abgriffs des Spannungsteilers mit der Deckelektroden-Metallisierung. Damit kann über das elektrische Potential dieser Deckelektroden-Metallisierung die Transistor-Durchbruchspannung beeinflußt und einstellbar gemacht werden, wobei dieses Potential durch die Einstellung bzw. Wahl der Einzelwiderstände des Spannungsteilers bestimmt ist. Durch den Basis-Ableitwiderstand wird verhindert, daß der Strom durch die Widerstände des Spannungsteilers den Transistor über seine Basis öffnet. Wenn die Durchbruchspannung gegenüber einem Wert von zwei Spannungsteilerwiderständen (Widerstand 1 geteilt durch die Summe der Widerstände 1 und 2) aufgetragen wird, ergibt sich ein ansteigender, linker Kurvenast bis zu einer Diskontinuität und ein rechter, abfallender Kurvenast. Zweckmäßig wird der Teilerabgriff so eingestellt, daß der Transistor-Arbeitspunkt im linken Teil der Kurve für die Durchbruchspannung liegt, da Arbeitspunkte im rechten Teil der Kurve zu einem stark instabilen Durchbruchverhalten führen.

Aber auch bei einer Lage des Arbeitspunktes im linken Teil dieser Kurve sind Veränderungen der Durchbruchspannung möglich. Ursachen dafür können beispielsweise Änderungen des Spannungsteilerverhältnisses aufgrund von mechanischen Verspannungen an den Widerständen sein. Weitere Ursachen können auch Änderungen der Durchbruchspannung des pn-Übergangs aufgrund einer Temperaturänderung in der Sperrschicht oder aufgrund von Ladungsträgern, die bei längerem Betrieb in das. Siliziumoxid eingelagert werden, sein. Die Stabilisierung der Durchbruchspannung ist wegen dieser Temperaturabhängigkeiten, Langzeitdriften und der Montageabhängigkeit nicht immer ausreichend.

### Vorteile der Erfindung

Bei der Darlington-Transistorschaltung mit den Merkmalen des Anspruchs 1 werden die Widerstände des Spannungsteilers nicht lediglich als Festwiderstände realisiert, sondern das Potential, das die Durchbruchspannung bestimmt, wird über eine zusätzliche Referenzspannung geregelt. Damit wird das Durchbruchspannungsverhalten von einer unabhängig zu realisierenden Referenzspannung bestimmt, wodurch die Temperaturabhängigkeit, Langzeitdrift und Montageabhängigkeit der Durchbruchspannungswerte beseitigt bzw. reduziert werden können. Diese Schaltungserweiterung ermöglicht es, das bekannte Spannungsbegrenzungsprinzip künftig auch in Applikationen einzusetzen, für die es bisher, z.B. aufgrund von sehr engen Toleranzanforderungen an die Spannungsbegrenzung, nicht einsetzbar war. Durch die allgemeine Abhängigkeit des Durchbruchspannungsverhaltens von der unabhängig zur realisierenden Referenzspannung lassen sich in dieser Weise auch andere Anforderungen an das Durchbruchspannungsverhalten darstellen, wie z.B ein definierter Temperaturkoeffizient $\neq 0$.

### Zeichnung

Die Erfindung wird anhand der Zeichnung näher erläutert.
Es zeigen:
Fig. 1    einen Ausschnitt aus dem Aufbau einer bekannten Darlington-Transistorschaltung,
Fig. 2    das elektrische Schaltbild der bekannten Darlington-Transistorschaltung nach Fig. 1,
Fig. 3    ein Diagramm der Kollektor-Emitter-Durchbruchspannung in Abhängigkeit von der Einstellung des Spannungsteilers aus Fig. 2,
Fig. 4    ein elektrisches Schaltbild des allgemeinen Regelprinzips zur Einstellung der Kollektor-Emitter-Durchbruchspannung,
Fig. 5    ein elektrisches Schaltbild einer ersten, konkreten Ausführungsform gemäß der Erfindung
Fig. 6    ein elektrisches Schaltbild einer zweiten, konkreten Ausführungsform gemäß der Erfindung.

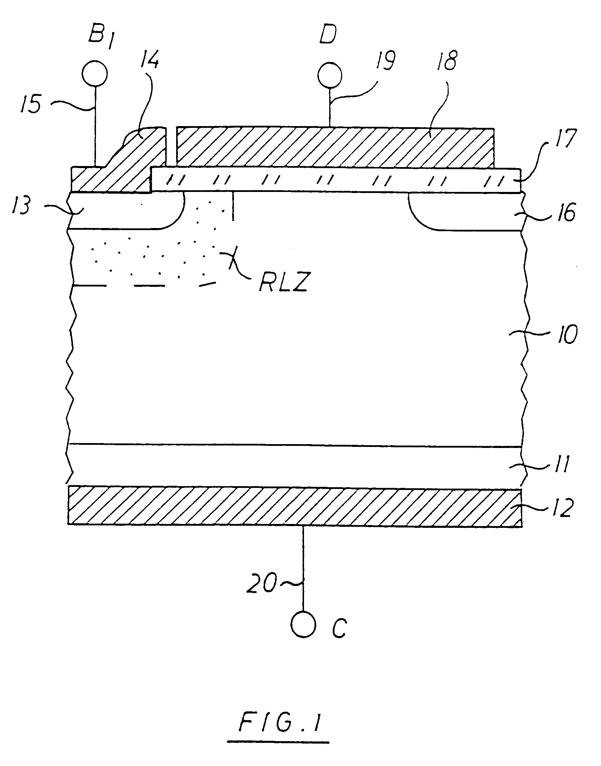

In Fig. 1 ist ein Schnitt durch das Layout einer Darlington-Schaltung dargestellt. Ein Substrat 10 besteht aus $n^-$-leitendem Silizium, an das sich nach unten hin ein $n^+$-Gebiet 11 mit einer Kollektor-Metallisierung 12 anschließt. Von der Hauptoberfläche ist eine p-leitende Basiszone eindiffundiert, über der eine Basis-Metallisierung 14 angebracht ist und an der schematisch ein Basis-Anschluß 15 für die Basis $B_1$ des Leistungstransistors $T_1$ einer Darlington-Schaltung dargestellt ist. Strichliert ist eine Raumladungszone RLZ eingezeichnet.

Weiter ist eine eindiffundierte $n^+$-Zone 16 dargestellt. Der Bereich zwischen den Zonen 13 und 16 wird über einer isolierenden Siliziumoxidschicht 17 von einer als Deckelektrode 18 wirkenden Metallisierung überdeckt, an der ebenfalls ein schematischer, externer Anschluß 19 dargestellt ist. Auch an der Kollektor-Metallisierung 12 ist ein externer Anschluß 20 zu einem gemeinsamen Kollektor C des Leistungstransistors $T_1$ und des Treibertransistors $T_2$ der Darlington-Schaltung eingezeichnet.

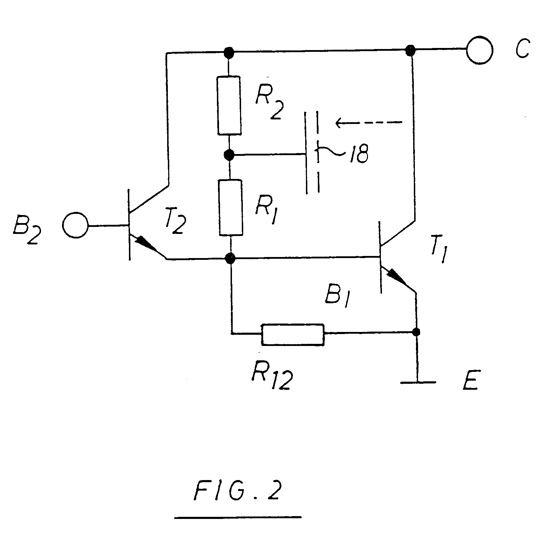

In Fig. 2 ist das elektrische Schaltbild der Anordnung nach Fig. 1 ergänzt um einen Spannungsteiler dargestellt. Es ist zu ersehen, daß zwischen dem gemeinsamen Kollektor-Anschluß C und zwischen dem Basis-Anschluß $B_1$ des Leistungstransistors $T_1$ ein Spannungsteiler aus den Widerständen $R_1$ und $R_2$ angebracht ist, wobei die Deckelektrode 18 mit dem Mittelabgriff dieses Spannungsteilers Verbindung hat. Über diese Verbindung erhält die Deckelektrode ein Potential, das von der Größe der Widerstände $R_1$ und $R_2$ und deren Verhältnis abhängt. Aus Fig. 1 ist zu ersehen, daß das Potential der Deckelektrode 18 auf die Raumladung RLZ wirkt und damit die Kollektor-Emitter-Durchbruchspannung beeinflußt und bestimmt, wobei eine weitere Abhängigkeit durch die Dicke der Siliziumoxidschicht 17 gegeben ist.

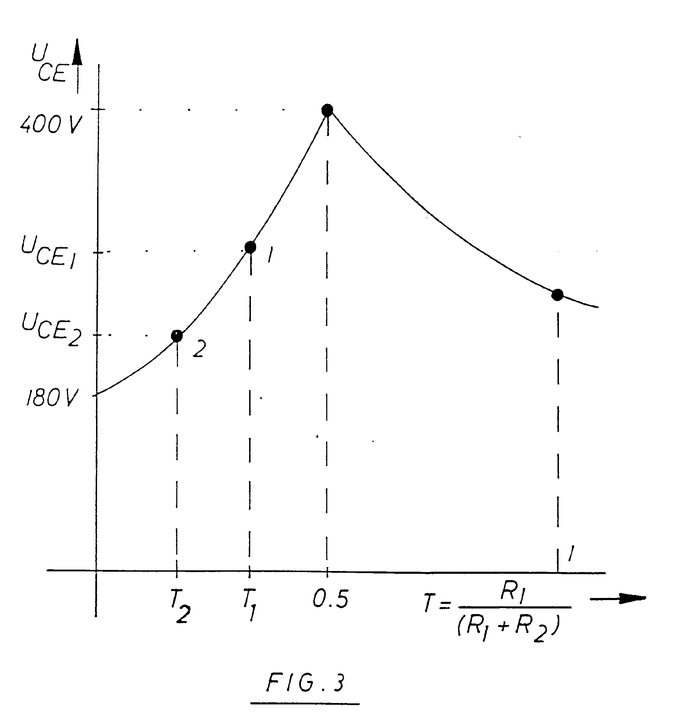

In Fig. 3 ist die Abhängigkeit dieser Durchbruchspannung $U_{CE}$ in Abhängigkeit des Teilerwertes T dargestellt, wobei

$$T = R_1/(R_1 + R_2)$$

ist. Es zeigt sich dabei, daß für Werte bis T = 0,5 die ermittelte Kurve in einem linken Teil kontinuierlich ansteigt und darüber hinaus in einem rechten Teil wieder kontinuierlich abfällt. Der oberste Punkt kann beispielsweise bei 400 V liegen und der Beginn des linken Kurvenastes z.B. bei 180 V. Beispielhaft sind für Werte $T_1$ und $T_2$ je ein Arbeitspunkt 1 und ein Arbeitspunkt 2 bei den entsprechenden Durchbruchspannungen $U_{CE1}$ und $U_{CE2}$ im linken Kurvenbereich eingezeichnet. Arbeitspunkte im rechten Kurvenbereich führen zu instabilen Verhältnissen.

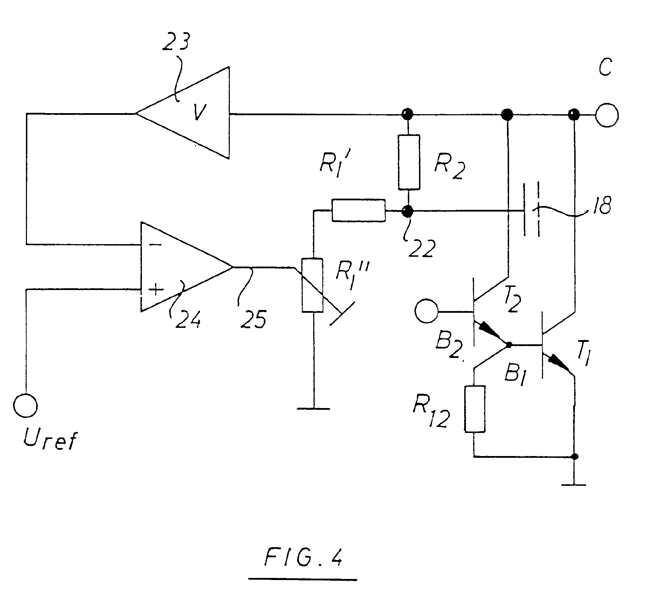

Die eingezeichneten Arbeitspunkte sind jedoch bei der Wahl einer Schaltungsanordnung nach Fig. 2 ebenfalls nicht absolut stabil und können sich aufgrund von Temperaturabhängigkeiten, Langzeitdriften, Verspannungen bei der Montage etc. ändern. Mit der erfindungsgemäßen Schaltungserweiterung nach Fig. 4, die auf dem Darlington-Chip mit integriert werden kann, wird eine ausreichende Stabilisierung der Durchbruchspannung $U_{CE}$ ermöglicht.

In Fig. 4 sind wiederum der Leistungstransistor $T_1$ und der Treibertransistor $T_2$ mit ihren Basisanschlüssen $B_1$ und $B_2$ zu erkennen sowie mit ihren gemeinsamen Kollektoranschlüssen C. Auch hier ist ein Spannungsteiler, ähnlich wie in Fig. 2 vorgesehen, wobei der Widerstand $R_2$ mit dem Kollektor C und dem mit der Deckelektrode 18 verbundenen Teilerabgriff 22 Verbindung hat.

Der Widerstand $R_1$ ist jedoch hier aufgeteilt in einen festen Widerstand $R_1'$ und einen steuerbaren, variablen Widerstand $R_1''$, der aber hier nicht mehr mit der Basisleitung zum Leistungstransistor, sondern mit Masse Verbindung hat. Die am Kollektor C anliegende Spannung wird geeignet umgeformt, beispielsweise über ein Verstärkungsglied 23 verstärkt und einem Vergleicher bzw. Regler 24 als Istwert zugeführt. Als Sollwert wird dieses Reglerglied 24 mit einer Referenzspannung $U_{ref}$ beaufschlagt. Bei Abweichungen zwischen Istwert und Sollwert wird über eine Steuerleitung 25 ein Signal zur Verstellung des Widerstandes $R_1''$ abgegeben. Damit wird das Potential der Deckelektrode 18 geändert und damit die Durchbruchspannung $U_{CE}$ ebenfalls verändert. Als Bedingung für eine geeignete Funktion des dargestellten Regelprinzips ergibt sich:

$$R_1'' = 0 \dots R_1''_{max}$$
$$R_1' + R_1''_{max} \leqq R_2.$$

In Fig. 4 ist der Regelkreis in Verbindung mit dem Widerstand $R_1$ dargestellt. Ein Regeleingriff über $R_2$ ist entsprechend möglich.

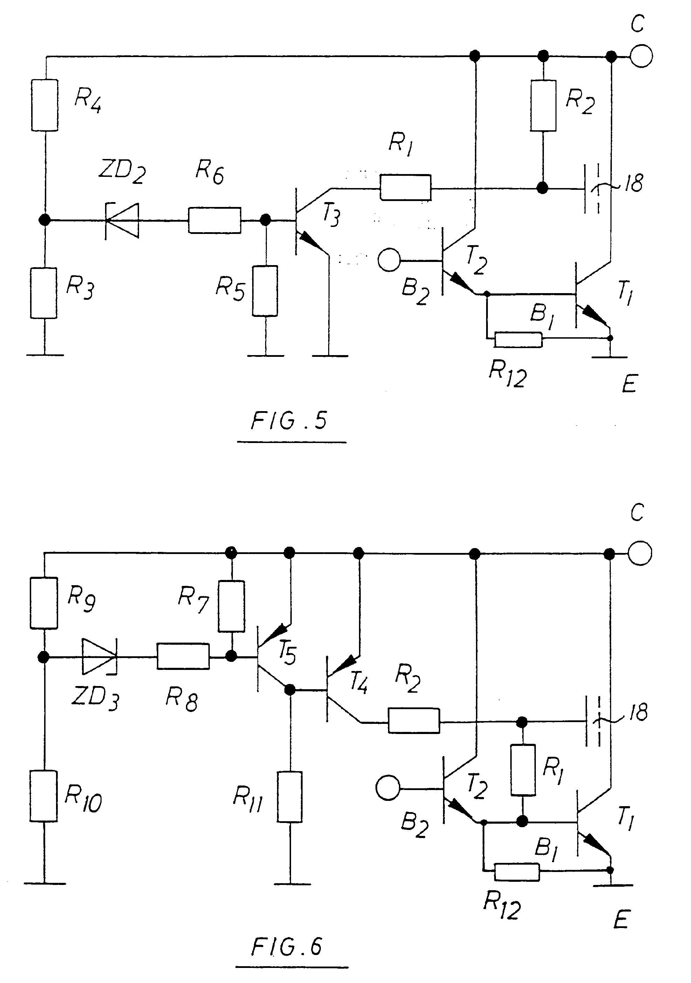

Die Schaltungsanordnung in Fig. 4 stellt schematisch das allgemeine Regelprinzip zur Einstellung der Transistordurchbruchspannung dar. Konkrete Ausführungen, bei denen die Schaltungsteile im Darlington-Chip monolithisch integrierbar sind, werden nachfolgend in den Fig. 5 und 6 dargestellt.

Die Schaltungsanordnungen in Fig. 5 und 6 stellen die erfindungsgemäßen Schaltungen dar.

In Fig. 5 is wiederum der Leistungstransistor $T_1$ mit seiner Basis $B_1$ und der Treibertransistor $T_2$ mit seiner Basis $B_2$ zu erkennen. Der Spannungsteiler aus den Widerständen $R_1$ und $R_2$ ist ähnlich wie in Fig. 4 mit dem Widerstand $R_2$ an den Kollektor C und die Deckelektrode 18 am Teilerabgriff angeschlossen. Der Widerstand $R_1$ liegt über die Kollektor-Emitter-Strecke eines Transistors $T_3$ an Masse. An der Basis dieses Transistors $T_3$ ist ein Spannungsteiler aus den Widerständen $R_5$ und $R_6$ mit seinem Teilerabgriff angeschlossen, wobei der Widerstand $R_5$ gegen Masse geführt ist und im Anschluß an den Widerstand $R_6$ eine Z-Diode $ZD_2$ liegt, die ihrerseits mit dem Spannungsabgriff eines weiteren Spannungsteilers aus den Widerständen $R_3$ und $R_4$ Verbindung hat. Der Widerstand $R_3$ ist dabei an Masse geführt, während der Widerstand $R_4$ mit dem gemeinsamen

Kollektor C der Transistoren $T_1$ und $T_2$ Verbindung hat.

Der Teilereingriff am Spannungteiler $R_1/R_2$ erfolgt hier über die gesteuerte Strom-/Spannungsquelle aus Kollektor-Emitter-Spannung-/Strom des Transistors $T_3$. Die Druchbruchspannung $U_{CE}$ wird über den Spannungteiler aus den Widerständen $R_3$ und $R_4$ heruntergeteilt und mit einer Referenzspannung verglichen. Als Referenzspannung dient der Spannungsabfall über der im Durchbruch betriebenen Z-Diode $ZD_2$, dem Widerstand $R_6$ und der Basis-Emitter-Spannung des Transistors $T_3$. Über das Teilerverhältnis der Widerstände $R_6$ und $R_6$ lassen sich der Wert und das Temperaturverhalten der Referenzspannung optimieren.

Auch in Fig. 6 ist der Leistungstransistor $T_1$ mit seiner Basis $B_1$ und der Treibertransistor $T_2$ mit seiner Basis $B_2$ sowie der gemeinsame Kollektor C zu erkennen. Auch hier ist der Spannungteiler aus den Widerständen $R_1$ und $R_2$ vorgesehen mit der Verbindung des Teilerabgriffs zu der Deckelektrode 18. Der Widerstand $R_1$ ist jedoch hier mit der Basis des Leistungstransistors $T_1$ verbunden, während dem Widerstand $R_2$ die gesteuerte Strom-/Spannungsquelle als Kollektor-Emitter-Spannung-/Strom des Transistors $T_4$ nachgeschaltet ist. Die über einen Spannungteiler aus den Widerständen $R_9$ und $R_{10}$ heruntergeteilte Durchbruchspannung $U_{CE}$ wird auch hier mit einer Referenzspannung verglichen. Als Referenzspannung dient hier der Spannungsabfall über ebenfalls einer im Durchbruch betriebenen Z-Diode $ZD_3$ und einem der Z-Diode $ZD_3$ nachgeschalteten Widerstand $R_8$ und der Basis-Emitter-Spannung eines Transistors $T_5$. Der Widerstand $R_8$ ist Teil eines Spannungsteilers mit einem weiteren Widerstand $R_7$, der mit dem Kollektor C Verbindung hat. Über das Teilerverhältnis $R_7/R_6$ lassen sich auch hier der Wert und das Temperaturverhalten der Referenzspannung optimieren.

Eine monolithische Integration der Schaltungsrealisierungen nach den Fig. 5 und 6 ist möglich.

## Patentansprüche

1. Darlington-Transistorschaltung mit einem Leistungstransistor ($T_1$) und mit einem Treibertransistor ($T_2$), dessen Kollektor an den Kollektor des Leistungstransistors ($T_1$) angeschlossen ist, bei der der Leistungstransistor ($T_1$) und der Treibertransistor ($T_2$) in einem gemeinsamen, die Kollektorzonen der beiden Transistoren ($T_1$, $T_2$) bildenden Substrat (10) eines Chips in Planartechnik monolithisch integriert sind, mit einem Basis-Ableitwiderstand ($R_{12}$), der zwischen der Basis ($B_1$) und dem Emitter (E) des Leistungstransistors ($T_1$) angeordnet ist, mit einer durch eine Siliziumoxid-Schicht (17) elektrisch isolierten Deckelektroden-Metallisierung (18) über der Raumladungszone (RLZ), die sich im Bereich des pn-Übergangs an der Chip-Oberseite zwischen Basis und Kollektor ausbildet, mit einem Spannungteiler (Widerstände $R_1$ und $R_2$) mit einer Verbindung des Abgriffs des Spannungsteilers ($R_1/R_2$) mit der Deckelektroden-Metallisierung (18), wobei über das elektrische Potential der Deckelektroden-Metallisierung (18) die Transistor-Durchbruchspannung (Kollektor-Emitter-Durchbruchspannung $U_{CE}$) einstellbar ist und dieses Potential durch die Einstellung des Spannungsteilers ($R_1/R_2$) bestimmt ist, dadurch gekennzeichnet, daß dieses Potential und damit die Durchbruchspannung ($U_{CE}$) über eine zusätzliche Referenzspannung geregelt wird, wobei die Widerstände ($R_1$, $R_2$) des Spannungsteilers über eine steuerbare Strom-/Spannungsquelle mit der Basis ($B_1$) des Leistungstransistors ($T_1$) bzw. dem gemeinsamen Kollektor (C) verbunden sind.

2. Darlington-Transistorschaltung nach Anspruch 1, dadurch gekennzeichnet, daß die Strom-/Spannungsquelle aus einer Transistorschaltung ($T_3$; $T_4$, $T_5$) besteht, in deren Basisansteuerung eine Z-Diode ($ZD_2$; $ZD_3$) leigt, die im Durchbruch betrieben wird und deren Durchbruchspannung zusammen mit der Spannung über einen nachgeschalteten Widerstand ($R_6$; $R_8$) und über der Basis-Emitter-Strecke eines Transistors ($T_3$; $T_5$) als Referenzspannung der gesteuerten Strom-/Spannungsquelle dient, mit der die über einen weiteren Spannungteiler ($R_3$ und $R_4$; $R_9$ und $R_{10}$) heruntergeteilte Durchbruchspannung ($U_{CE}$) verglichen wird.

## Claims

1. Darlington transistor circuit having a power transistor ($T_1$) and having a driver transistor ($T_2$) whose collector is connected to the collector of the power transistor ($T_1$), in which the power transistor ($T_1$) and the driver transistor ($T_2$) are monolithically integrated into a common substrate (10), forming the collector zones of the two transistors ($T_1$, $T_2$), of a planar technology chip, having a base bleed resistor ($R_{12}$) which is arranged between the base ($B_1$) and the emitter (E) of the power transistor ($T_1$), having a covering electrode metallisation (18), which is made electrically insulating by means of a silicon oxide layer (17), over the space-charge zone (RLZ) which is constructed in the region of the pn-junction on the chip upper side between the base and the collector, having a voltage divider (resistors $R_1$ and $R_2$) with a connection of the pick-off of the voltage divider ($R_1/R_2$) to the covering electrode metallisation (18), the transistor breakdown voltage (collector-emitter breakdown voltage $U_{CE}$) being adjustable via the electrical potential of the covering electrode metallisation (18) and this potential being determined by the setting of the voltage divider ($R_1/R_2$), characterised in that this potential and hence the breakdown voltage ($U_{CE}$) are regulated via an additional reference voltage, the resistors ($R_1$, $R_2$) of the voltage divider being connected via a controllable current/voltage source to the base ($B_1$) of the power transistor ($T_1$) and to the common collector (C), respectively.

2. Darlington transistor circuit according to Claim 1, characterised in that the current/voltage source consists of a transistor circuit ($T_3$; $T_4$, $T_5$) in whose base drive a Zener diode ($ZD_2$; $ZD_3$) is located, which is operated in the breakdown mode, and whose breakdown voltage is used, together with the voltage over a downstream resistor ($R_6$; $R_8$) and over the base-emitter junction of a transistor ($T_3$; $T_5$), as the reference voltage of the controlled current/voltage source with which the breakdown voltage ($U_{CE}$), divided down via a further voltage divider ($R_3$ and $R_4$; $R_9$ and $R_{10}$) is compared.

## Revendications

1. Montage Darlington comprenant un transistor de puissance ($T_1$) et un transistor de commande ($T_2$) dont le collecteur est relié au collecteur du transistor de puissance ($T_1$), le transistor de puissance ($T_1$) et le transistor de commande ($T_2$) étant intégrés de manière monolithique en technique planaire dans un support (10) d'une plaquette formant les zones de collecteur des deux transistors ($T_1$, $T_2$), avec une résistance de sortie de base ($R_{12}$) montée entre la base ($B_1$) et l'émetteur (E) du transistor de puissance ($T_1$), une métallisation (18) formant une électrode de recouvrement, isolée électriquement par une couche d'oxyde de silicium (17) au-dessus de la zone de charge d'espace (RLZ) qui se développe dans la zone de la jonction pn sur la face supérieure de la plaquette entre la base et le collecteur, un diviseur de tension (résistances $R_1$ et $R_2$) avec une liaison de la prise médiane du diviseur de tension ($R_1/R_2$) et de la métallisation de l'électrode de recouvrement (18), le potentiel électrique de la métallisation (18) de l'électrode de recouvrement réglant la tension de claquage du transistor (tension de claquage collecteur-émetteur $U_{CE}$) dont le potentiel est défini par le réglage du diviseur de tension ($R_1/R_2$), caractérisé en ce que ce potentiel et ainsi la tension de claquage ($U_{CE}$), sont réglés par une tension de référence supplémentaire, les résistances ($R_1/R_2$) du diviseur de tension étant reliées par une source de courant/tension commandée, à la base ($B_1$) du transistor de puissance ($T_1$) ou du collecteur commun (C).

2. Montage Darlington selon la revendication 1, caractérisé en ce que la source de courant/tension se compose de transistors ($T_3$ ; $T_4$, $T_5$) dont la commande de base comprend une diode de type Z ($ZD_2$ ; $ZD_3$) travaillant en claquage, et en ce que sa tension de claquage, avec la tension d'une résistance en aval ($R_6$ ; $R_6$) et celle du chemin base-émetteur d'un transistor ($T_3$ ; $T_5$), constitue la tension de référence pour la source de courant/tension, commandée, tension de référence à laquelle on compare la tension de claquage ($U_{CE}$) divisée par un autre diviseur de tension ($R_3$ et $R_4$ ; $R_9$ et $R_{10}$).

FIG.1

FIG. 2

FIG.3

FIG. 4

FIG.5

FIG.6